Europäisches Patentamt

European Patent Office

Office européen des brevets

(11) Numéro de publication: **0 082 787**
**B1**

(12) **FASCICULE DE BREVET EUROPEEN**

(45) Date de publication du fascicule du brevet: **10.06.87**

(51) Int. Cl.⁴: **H 01 L 31/10**

(21) Numéro de dépôt: **82402340.2**

(22) Date de dépôt: **21.12.82**

(54) Photodiode à zones d'absorption et d'avalanche séparées.

(30) Priorité: **23.12.81 FR 8124164**

(43) Date de publication de la demande:
**29.06.83 Bulletin 83/26**

(45) Mention de la délivrance du brevet:
**10.06.87 Bulletin 87/24**

(84) Etats contractants désignés:
**DE GB NL**

(56) Documents cités:
**EP-A-0 053 513**
**DE-A-2 707 180**
**GB-A-2 025 693**

**ELECTRONICS LETTERS, vol. 15, no. 15, juillet
1979, pages 453-455, New York, US, K.
TAGUCHI et al.:"InP-InGaAsP planar avalanche
photodiodes with self-guard-ring effect"**

**IEEE JOURNAL OF QUANTUM ELECTRONICS,
vol. QE-17, no. 2, février 1981, pages 250-254,
IEEE, New York, US, H. ANDO et
al.:"InGaAs/InP separated absorption and
mulitplication regions avalanche photodiode
using liquid- and vapor-phase epitaxies"**

(73) Titulaire: **THOMSON-CSF**
**173, Boulevard Haussmann**
**F-75379 Paris Cedex 08 (FR)**

(72) Inventeur: **Poulain, Pierre**
**THOMSON-CSF SCPI 173, bld Haussmann**
**F-75379 Paris Cedex 08 (FR)**
Inventeur: **de Cremoux, Baudoin**
**THOMSON-CSF SCPI 173, bld Haussmann**
**F-75379 Paris Cedex 08 (FR)**

(74) Mandataire: **Taboureau, James et al**
**THOMSON-CSF SCPI 19, avenue de Messine**
**F-75008 Paris (FR)**

Courier Press, Leamington Spa, England.

## Description

L'invention concerne une photodiode à zones d'absorption et d'avalanche séparées, opérant dans le domaine 1,2—1,6 micron, réalisée en utilisant des matériaux des familles III—V, et possèdant un gain par avalanche élevé, bien que le facteur de bruit soit faible.

L'invention concerne plus précisément la structure des couches semiconductrices qui constituent une photodiode à avalanche: l'optimisation de cette structure, par des modifications géométriques des couches ou des prises de contact par exemple, fait partie des connaissances de l'art et certains perfectionnements aux photodiodes à avalanche sont déjà connus, par exemple des demandes de brevets FR—A—2 311 408, FR—A—2 396 419 et FR—A—2 406 896 de la société demanderesse.

L'invention sera exposée en s'appuyant sur l'exemple d'une photodiode présentant deux hétérojonctions InP/GaInAs, mais d'autres matériaux tels que GaAsSb, GaAlAsSb, GaSb entrent dans le domaine d'application de l'invention, pourvu qu'ils soient adaptés entre eux en mailles cristallines.

Une photodiode à avalanche est un dispositif semiconducteur qui ajoute à l'effet photodétecteur un effet amplificateur dû à l'avalanche. Ce type de dispositif est très utilisé dans le domaine des télécommunications sur fibres optiques.

Une photodiode à zones d'absorption et d'avalanche séparées, comprend, parmi d'autres, une couche d'absorption des photons dans laquelle les photons incidents créent des paires électrons-trous. Sous l'effet d'une polarisation inverse, dans une couche ayant une concentration de dopage et une épaisseur telles qu'elle soit au moins partiellement en charge d'espace, ou que la longueur de diffusion des porteurs soit grande, un courant se produit par échange des électrons et des trous. Le potentiel de polarisation appliqué étant supposé suffisant, les électrons s'écoulent vers la première région formant une première hétérojonction avec la couche d'absorption, tandis que les trous s'écoulent dans un sens opposé, vers une deuxième région formant une deuxième hétérojonction avec la couche d'absorption, deuxième région dans laquelle ils déclenchent le phénomène d'avalanche dû à un fort champ électrique.

L'intérêt d'initier l'avalanche par les trous dans le cas des matériaux III—V, et InP plus particulièrement, est que le bruit apporté par l'amplification est plus faible que dans le cas où elle est initiée par des électrons.

Il est maintenant bien établi que pour réaliser des photodiodes à avalanche à base de composés III—V, dans le domaine spectral de 1,2—1,6 micromètre, il faut utiliser des hétérostructures telles que la zone de fort champ électrique, de l'ordre de $10^5$ V/cm, dans laquelle se produit l'avalanche soit située dans un matériau à grande bande interdite, l'absorption de lumière se faisant dans une zone adjacente à petite bande interdite.

Par exemple, dans Electronics Letters, vol. 15, No. 15, juillet 1979, pp. 453—455, l'article intitulé "InP-InGaAsP planar avalanche photodiodes with self-guard-ring effect" décrit une photodiode dans laquelle l'avalanche se produit dans une couche de n InP—à grande bande interdite—et l'absorption se produit dans une couche de N InGaAsP—à petite bande interdite—les deux couches formant une hétérojonction. L'intérêt de cet article est de décrire une diode planar, alors que les diodes au germanium connues étaient précédemment mésa, dont la structure du contact améliore le courant d'obscurité.

Par ailleurs, le document EP—A—0 053 513 compris dans l'état de la technique conformément à l'article 54(3) décrit une photodiode à zones d'absorption et d'avalanche séparées, comprenant, un substrat porteur d'une première métallisation de prise de contact électrique, une hétérostructure formée par une couche d'absorption de la lumière, en matériau à faible bande interdite, et par une première couche qui supporte une deuxième couche, ces deux couches étant en matériau à grande bande interdite, l'ensemble du substrat et des couches de l'hétérostructure étant d'un premier type de conductivité, et formant jonction avec une couche d'un second type de conductivité et porteuse d'une seconde métallisation de prise de contact,

la deuxième couche à grande bande interdite étant la couche d'avalanche,

la première couche à grande bande interdite étant moins épaisse mais plus dopée que la couche d'avalanche, et constituant une couche d'abaissement du champ électrique.

D'autre part, la mesure des coefficients d'ionisation des porteurs de charge dans le matériau semiconducteur montre que ceux-ci sont d'autant plus dissymétriques, pour les électrons et les trous, que le champ électrique décroît. Mais, comme le bruit dû à l'amplification par avalanche est d'autant plus grand que le rapport de ce coefficient d'ionisation se rapproche de l'unité, les structures connues ont leur gain utile limité à des valeurs faibles, de l'ordre de 10. Par conséquent, pour pouvoir augmenter le gain d'une photodiode à avalanche, il est nécessaire d'opérer avec un champ électrique moins élevé de façon à ce que les coefficients d'ionisation soient davantage dissymétriques, tout en conservant un bruit dû à l'amplification peu élevé. C'est l'objet de l'invention que de réaliser une photodiode à zone d'absorption et d'avalanche séparées possèdant un gain par avalanche élevé et simultanément un faible facteur de bruit.

Selon l'invention, on obtient un gain appréciable avec un champ faible en augmentant la longueur sur laquelle ce champ s'exerce, c'est-à-dire en remplaçant la région d'avalanche des structures connues, région d'avalanche peu épaisse mais sous fort champ électrique, par une région d'avalanche plus longue et sous faible champ électrique. Ainsi, statistiquement le gain obtenu par avalanche est le même. Ceci est obtenu en intercalant une couche à grande bande interdite et faiblement dopée entre la couche d'abaissement du champ électrique et la couche fenêtre ou couche de prise de contact par métallisation sur le corps de la diode, afin que la zone d'avalanche s'étende sur une distance suffisante pour obtenir un gain élevé sous champ électrique faible.

De façon plus précise, l'invention concerne une photodiode à zones d'absorption et d'avalanche séparées, comprenant un substrat porteur d'une première métallisation de prise de contact électrique, une hétérostructure formée par une couche d'absorption de la lumière, en matériau à faible bande interdite, et par une première couche qui supporte une deuxième couche, ces deux couches étant en matériau à grande bande interdite, l'ensemble du substrat et des couches de l'hétérostructure étant d'un premier type de conductivité et formant jonction avec une couche d'un second type de conductivité et porteuse d'une seconde métallisation de prise de contact, ladite photodiode étant remarquable en ce que:

— la deuxième couche à grande bande interdite, dite couche d'avalanche, est de grande épaisseur et de faible niveau de dopage, ces deux caractéristiques étant de plus liées par la relation $n_2x_2 < 1,3 \cdot 10^{12}$ at.cm$^{-2}$, de sorte que le phénomène d'avalanche, confiné dans la deuxième couche, se produit sur une grande longueur mais sous une faible variation du champ électrique,

— la première couche à grande bande interdite, est moins épaisse, mais plus dopée que la couche d'avalanche, ces deux caractéristiques étant de plus liées par la relation $n_1x_1 \simeq 2,5 \cdot 10^{12}$ at.cm$^{-2}$, et constitue une couche d'abaissement du champ électrique.

L'invention sera mieux comprise par la description qui suit d'un exemple de réalisation, cette description s'appuyant sur les figures jointes en annexe qui représentent:

— figure 1: structure et profil du champ électrique pour une photodiode à avalanche selon l'art connu;

— figure 2: structure et profil du champ électrique pour une photodiode à avalanche selon l'invention.

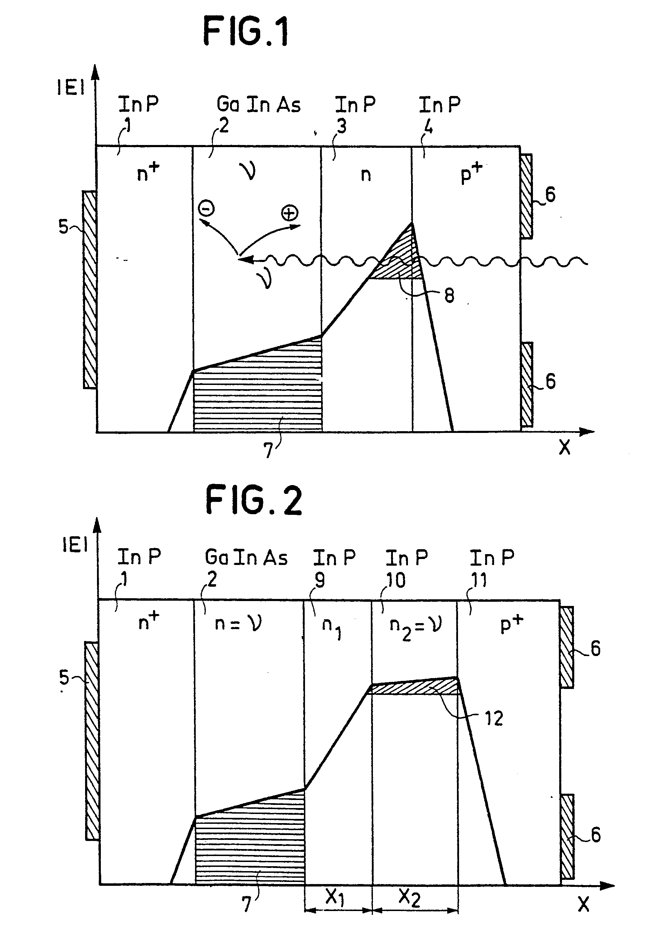

La figure 1 représente la structure d'une photodiode à zones d'absorption et d'avalanche séparées selon l'art connu. La géométrie d'une telle photodiode s'y prêtant, on a superposé à la représentation de la structure par couches de semiconducteurs la représentation du diagramme ou du profil du champ électrique, sur le dessin de la structure.

Dans le but de simplifier les explications, cette diode à avalanche selon l'art connu est choisie en InP/GaInAs, dont les différentes couches sont de type n et p.

Une telle photodiode à avalanche est composée d'un substrat n+ en InP repéré 1: dans la réalité, cette couche 1 est composée du substrat lui-même et d'une couche tampon ou buffer de même matériau et de même type de conductivité, la couche tampon étant destinée à lisser la surface relativement rugueuse du substrat. Sur le substrat 1 est déposée une couche 2 de GaInAs de type de conductivité n, que l'on appellera ν parce que c'est une zone n peu dopée. Avec la zone d'absorption des photons, une couche 3 d'InP de type n forme une hétérojonction, de grande bande interdite, alors que la couche d'absorption est à faible bande interdite. Enfin, une couche de contact 4 en InP de type de conductivité p+ assure la prise de contact avec la métallisation d'électrode. Une telle diode est complétée par deux métallisations d'électrodes 5 du côté du substrat et 6 du côté de la fenêtre par laquelle pénètre la lumière détectée par cette diode à avalanche. Les métallisations de prise de contact, tout comme la représentation des différentes couches composant la structure d'une telle photodiode, sont très schématisées.

La région superficielle du côté de la prise de contact 6 constitue une fenêtre pouvant jouer le rôle de filtre limitant vers les courtes longueurs d'onde le spectre de la lumière reçue par le dispositif utilisé en photodétecteur. Elle constitue en même temps, du fait de son dopage élevé, une région de prise de contact et sa localisation permet de limiter la région d'absorption du dispositif à l'aire strictement utile, par exemple l'aire très petite correspondante à la section d'une fibre optique ou d'un faisceau de fibres optiques. Lorsqu'un photon ν pénètre dans la photodiode par la fenêtre constituée dans la métallisation 6, il traverse les couches superficielles 3 et 4 et est détecté et absorbé dans la couche d'absorption 2 dans laquelle il crée une paire électron-trou. Sous l'action d'un champ électrique, exercé par la polarisation inverse qui est appliquée aux bornes de la diode, les électrons et les trous se séparent, les électrons étant dirigés vers le substrat 1 tandis que les trous sont dirigés vers la couche 3 et la région superficielle.

L'axe horizontal du dessin représentant les distances ou les épaisseurs de couches, on a porté en axe vertical le champ électrique E, en valeur absolue, développé par la polarisation. Ce champ est de peu d'importance dans le substrat, mais dans la couche d'absorption 2, il atteint une valeur de l'ordre de $10^5$ V/cm au maximum, au-delà de laquelle il y aurait risque de claquage de la diode par effet tunnel. Puis, dans la couche 3 à grande bande interdite, il y a élévation du champ, jusqu'à un maximum dans lequel se produit l'avalanche, tandis que dans la couche 4 de prise de contact le champ retombe brutalement au-delà de la jonction entre les couches 3 et 4, à une valeur très faible. Sur le diagramme de champ superposé au diagramme de structure dans la figure 1, la zone de détection et d'absorption des photons est représentée par la zone 7, tandis que la zone d'avalanche est représentée en 8: la zone d'avalanche a une épaisseur de l'ordre de 10 nm (100 Å).

La variaton brutale de champ dans la couche 3 peut être considérée selon le cas comme une élévation du champ selon qu'il s'agit des trous qui se dirigent de la zone 2 vers la zone 3 ou comme un abaissement du champ si l'on considère le trajet des photons: toujours est-il que ce champ varie fortement en fonction de la distance x et que par conséquent comme cela a été dit, il se produit statistiquement un bruit élevé dû à une amplification brutale par avalanche, ce bruit étant d'autant plus grand que le rapport des coefficients d'ionisation approche de l'unité, c'est-à-dire que le champ électrique est élevé.

Selon l'invention, le bruit est diminué tout en conservant un gain dû à l'avalanche élevé, la zone d'avalanche s'étendant sur une distance suffisante pour obtenir un gain sous champ électrique faible. C'est ce que représente la figure 2 qui donne le schéma de structure d'une diode à avalanche selon l'invention.

La figure 2 est à rapprocher de la figure 1 en ce sens qu'elle donne selon l'axe des x les différentes couches semiconductrices qui composent une photodiode à avalanche et, superposée selon l'axe des y, la courbe du champ électrique E en valeur absolue dans ces mêmes couches.

De façon à être comparable à l'exemple cité de l'art connu, l'exemple d'application de l'invention décrite utilise le composé III—V $Ga_xIn_{1-x}As$, qui permet de couvrir le domaine spectral de 1 à 1,7 micromètre lorsqu'il est adapté en maille cristalline à un substrat InP. Mais, comme il a été dit, d'autres matériaux sont utilisables qui entrent dans le domaine de l'invention.

Le substrat 1 en InP de type de conductivité n+ est composé d'une couche de substrat à proprement parler et d'une couche tampon destinée à lisser la surface du substrat: sur ce substrat 1 est déposée par épitaxie en phase vapeur, une couche 2, qui est la couche d'absorption, en $Ga_xIn_{1-x}As$ correspondant à la composition x=0,47, et de dopage $n < 2.10^{15}$ atomes d'impureté ionisés par $cm^3$, cette couche ayant une épaisseur de 2 microns environ.

Ensuite, est déposée une couche InP dopée $n_1$, et d'épaisseur $x_1$ telle qu $n_1 . x_1 \approx 2,5\ 10^{12}$ atomes d'impureté ionisés par $cm^2$. A titre d'exemple, $n_1 = 5.10^{16}$ atomes/$cm^3$ et $x_1 = 0,5$ µm. Cette couche d'abaissement du champ est repérée 9 sur la figure 2 pour la différencier de la couche 3 de la figure 1. Cette couche 9 doit répondre à la condition $n_1 x_1 \approx 2,5\ 10^{12}$ atomes/$cm^2$. Sur la couche d'abaissement de champ 9 est déposée une couche d'InP repérée 10 dopée $n_2$: cette couche est épaisse et, avant les opérations qui seront décrites ultérieurement, elle va jusqu'à la métallisation 6 de prise de contact. Cette couche 10 est, comme la couche 2, repérée par le signe v, qui indique qu'elle est peu dopée.

La jonction électrique pn nécessaire pour faire une diode de ce type, est formée par implantation ou diffusion dans la couche d'Inp 10 d'un dopant de type p à travers un masque d'oxyde, et jusqu'à une profondeur telle que l'on ait la condition $n_2 . x_2 < 1,3\ 10^{12}$ at/$cm^2$, $x_2$ étant la distance séparant la jonction de l'interface entre les deux couches d'InP 9 et 10. Cette opération d'implantation ou de diffusion forme donc dans la couche 10 de type $n_2$ la couche 11 de type p+ représentée sur la figure 2.

Les contacts ohmiques sont ensuite réalisés par des moyens connus de métallisation avec une géométrie permettant la transmission de la lumière sur au moins l'une des faces: sur la figure représentée, le contact ohmique 5 sur la couche n+ qui est le substrat n'est pas transparent à la lumière et c'est le contact ohmique 6 sur la couche p+ 11 qui présente une fenêtre, pour le passage d'un fibre optique par exemple.

Si l'on considère maintenant le diagramme de champ électrique qui est rapporté et superposé sur cette structure de diode, la zone de détection est, commde dans la diode de l'art connu, la zone 7 dans la couche d'absorption 2. Cette zone de détection correspond à un champ électrique maximum de $10^5$ volts/cm. La zone d'avalanche est repérée 12 et elle correspond à un minimum de $4,5 \times 10^5$ Volts/cm. Cette zone d'avalanche s'étend à travers la couche d'avalanche InP 10, couche dans laquelle le champ varie peu, mais varie sur une distance suffisante pour que le produit de l'amplification par unité de distance multiplié par l'épaisseur de la couche donne un gain important.

La structure décrite est du type nvnvp: toutefois, si les matériaux utilisés pour réaliser une photodiode à avalanche sont tels que le coefficient d'ionisation des électrons est supérieur à celui des trous, il suffit alors de réaliser une structure de type pπpπn pour obtenir une photodiode à avalanche jouissant des mêmes caractéristiques de gain élevé et de faible bruit en excès à l'amplification. Cependant, comme un faible bruit en excès est obtenu pour des coefficients d'ionisation très différents, il est préférable d'injecter dans la zone d'avalanche le porteur de plus fort coefficient d'ionisation, c'est pourquoi le cas le plus général est le cas d'une diode nvnvp.

Enfin, l'invention a été exposée en précisant, dans le seul but de simplifier les explications, que les matériaux sont InP et GaInAs: il a été dit précédemment que d'autres matériaux tels que GaAlSb, GaAlAsSb, GaSb par exemple conviennent parfaitement.

En outre, la structure de la diode a été exposée dans son schéma le plus général, qui correspond à celui de couches de matériaux semiconducteures. Rien n'empêche de perfectionner cette diode en donnant aux différentes couches énoncées des formes qui permettent d'optimiser la diode selon l'invention, qui est précisée par les revendications ci-après.

## Revendications

1. Photodiode à zones d'absorption et d'avalanche séparées, comprenant, un substrat (1) porteur d'une première métallisation (5) de prise de contact électrique, une hétérostructure formée par une couche (2) d'absorption de la lumière, en matériau à faible bande interdite, et par une première couche (9), qui supporte une deuxième couche (10), ces deux couches étant en matériau à grande bande interdite, l'ensemble du substrat (1) et des couches de l'hétérostructure (2, 9, 10) étant d'un premier type de conductivité, et formant jonction avec une couche (11) d'un second type de conductivité et porteuse d'une seconde métallisation (6) de prise de contact,

la deuxième couche (10) à grande bande interdite, dite couche d'avalanche, étant de grande épaisseur ($x_2$) et de faible niveau de dopage ($n_2$), ces deux caractéristiques étant de plus liées par la relation $n_2x_2 < 1,3 . 10^{12}$ at.cm$^{-2}$, de sortie que le phénomène d'avalanche, confiné dans la deuxième couche (10), se produit sur une grande longueur mais sous une faible variation du champ électrique,

la première couche (9) à grande bande interdite, étant moins épaisse ($x_1$) mais plus dopée ($n_1$) que la couche d'avalanche (10), ces deux caractéristiques étant de plus liées par la relation $n_1x_1 \simeq 2,5 . 10^{12}$ at.cm$^{-2}$, et constituant une couche d'abaissement du champ électrique.

2. Photodiode selon la revendication 1, caractérisé en ce que sa structure est de type n+vnvp+; substrat (1) n+, couche d'absorption (2) v, couche d'abaissement du champ électrique (9) n, couche d'avalanche (10) v, couche de jonction (11) p+, l'avalanche étant déclenchée par des trous.

3. Photodiode selon la revendication 1, caractérisée en ce que sa structure est de type p+πpπn+: substrat (1) p+, couche d'absorption (2) π, couche d'abaissement du champ électrique (9) p, couche d'avalanche (10) π, couche de jonction (11) n+, l'avalanche étant déclenchée par des électrons.

4. Photodiode selon la revendication 1, caractérisée en ce que le matériau du substrat (1), des couches d'abaissement du champ électrique (9), d'avalanche (10) et de jonction (11) étant InP à grande bande interdite, l'hétérostructure est formée par une couche à faible bande interdite (2) en Ga$_x$In$_{1-x}$As, avec x=0,47.

5. Photodiode selon la revendication 1, caractérisée en ce que le matériau du substrat (1), des couches d'abaissement du champ électrique (9), d'avalanche (10) et de jonction (11) étant GaSb à grande bande interdite, l'hétérostructure est formée par une couche à faible bande interdite (2) en matériau adapté en paramètre de maille cristalline choisi parmi GaAlSb ou GaAlAsSb.

**Patentansprüche**

1. Photodiode mit getrennten Absorptions- und Avalanchezonen, mit einem eine erste Metallisation (5) zur elektrischen Kontaktgabe tragenden Substrat (1), mit einer Heterostruktur, die von einer lichtabsorbierenden Schicht aus einem Material mit schmalem verbotenen Band und von einer ersten Schicht (9) gebildet wird, die eine zweite Schicht (10) trägt, wobei diese beiden Schichten aus einem Material mit breitem verbotenen Band bestehen und wobei die aus dem Substrat (1) und den Schichten der Heterostruktur (2, 9, 10) gebildete Einheit von einem ersten Leitfähigkeitstyp ist und eine Junktion mit einer Schicht (11) eines zweiten Leitfähigkeitstyps bildet, die eine zweite Metallisation (6) zur Kontaktgabe trägt, wobei die zweite Schicht (10) mit breitem verbotenen Band, Avalancheschicht genannt, eine große Dicke ($x_2$) und einen niedrigen Dotierungsgrad ($n_2$) besitzt, und diese beiden Kennwerte zusätzlich durch die Beziehung $n_2x_2 < 1,3 . 10^{12}$ at.cm$^{-2}$ verbunden sind, derart, daß das in der zweiten Schicht (10) eingeschlossene Avalanchephänomen sich über eine große Länge, aber unter einer geringen Variation des elektrischen Felds ergibt, wobei die zweite Schicht (9) mit breitem verbotenen Band weniger dick ($x_1$), aber stärker dotiert ($n_1$) als die Avalancheschicht (10) ist und diese Kennwerte außerdem durch die Beziehung $n_1 . x_1 \simeq 2,5 . 10^{11}$ at.cm$^{-2}$ verbunden sind, und wobei die erste Schicht (9) eine Schicht zur Absenkung des elektrischen Feldes bildet.

2. Photodiode nach Anspruch 1, dadurch gekennzeichnet, daß ihre Struktur vom Typ n+vnvp+ ist, nämlich Substrat (1) n+, Absorptionsschicht (2) v, Schicht zur Absenkung des elektrischen Feldes (9) n, Avalancheschicht (10) v, Junktionsschicht (11) p+, wobei die Lawine durch Löcher ausgelöst wird.

3. Photodiode nach Anspruch 1, dadurch gekennzeichnet, daß ihre Struktur vom Typ p+πpπn+ ist, nämlich Substrat (1) p+, Absorptionsschicht (2) π, Schicht zur Absenkung des elektrischen Feldes (9) p, Avalancheschicht (10) π, Junktionsschicht (11) n+, wobei die Lawine durch Elektronen ausgelöst wird.

4. Photodiode nach Anspruch 1, dadurch gekennzeichnet, daß als Material für das Substrat (1), die Schicht zur Absenkung des elektrischen Feldes (9), die Avalancheschicht (10) und die Junktionsschicht (11) InP mit breitem verbotenen Band verwendet wird und die Heterostruktur durch eine Schicht mit schmalem verbotenen Band (2) aus Ga$_x$In$_{1-x}$As gebildet wird mit x=0,47.

5. Photodiode nach Anspruch 1, dadurch gekennzeichnet, daß als Material für das Substrat (1), die Schicht zur Absenkung des elektrischen Felds (9), die Avalancheschicht (10) und die Junktionsschicht (11) GaSb mit breitem verbotenen Band verwendet wird und die Heterostruktur von einer Schicht mit schmalem verbotenen Band (2) aus einem Material mit bezüglich des Parameters des Gitterabstands angepaßtem Material gebildet wird, das ausgewählt wird aus GaAlSb und GaAlAsSb.

**Claims**

1. A photodiode with separated absorption and avalanche zones, comprising a substrate (1) on which a first metallisation (5) constituting an electric contact is deposited, and a heterostructure constituted by a light absorbing layer (2) made of a material having a small forbidden band, and by a first layer (9) which supports a second layer (10), these two layers being made from a material having a large forbidden band, the assembly constituted by the substrate (1) and the layers of the heterostructure (2, 9, 10) being of a first conductivity type and constituting a junction with a layer (11) of a second conductivity type bearing a second contact metallisation (6), the second layer (10) of a large forbidden band, called avalanche layer, having a great thickness $(x_2)$ and a low doping rate $(n_2)$, these two characteristics being further linked by the relation $n_2 . x_2 < 1,3 . 10^{12}$ at.cm$^{-2}$ in such a way that the avalanche phenomenon, enclosed in the second layer (10) develops on a great length but under a low electric field variation rate, the first layer (9) of a large forbidden band being less thick $(x_1)$ but doped at a higher rate $(n_1)$ than the avalanche layer (10), these two characteristics being further linked by the relation $n_1 . x_1 \simeq 2,5 . 10^{12}$ at.cm$^{-2}$, this first layer (9) constituting a layer for lowering the electric field.

2. A photodiode according to claim 1, characterized in that its structure is of the type n+vnvp+, that means substrate (1) n+, absorbing layer (2) v, electric field lowering layer (9) n, avalanche layer (10) v, junction layer (11) p+, the avalanche being triggered by holes.

3. A photodiode according to claim 1, characterized in that its structure is of the type p+πpπn+, that means substrate (1) p+, absorbing layer (2) π, electric field lowering layer (9) p, avalanche layer (10) π, junction layer (11) n+, the avalanche being triggered by electrons.

4. A photodiode according to claim 1, characterized in that the substrate (1), the electric field lowering layer (9), the avalanche layer (10) and the junction layer (11) being made of InP having a large forbidden band, the heterostructure is constituted by a layer of small forbidden band (2) made of $Ga_xIn_{1-x}As$, with x=0,47.

5. A photodiode according to claim 1, characterized in that the substrate (1), the electric field lowering layer (9), the avalanche layer (10) and the junction layer (11) being made of GaSb having a large forbidden band, the heterostructure is constituted by a layer having a small forbidden band (2) and being made of a material the crystal lattice parameter of which is adapted and which is chosen among GaAlSb and GaAlAsSb.

# FIG.1

# FIG.2